# EUROPEAN PATENT SPECIFICATION

(11) **EP 0 455 992 B1**
(45) Date of publication and mention of the grant of the patent: **21.05.1997**
(21) Application number: 91105498.9
(22) Date of filing: 08.04.1991
(51) Int. Cl.: H04L 1/00, H03M 13/00

(54) **Electronic device for parallel correction of data streams protected with error detection by cyclic redundancy check**
Elektronisches Gerät für die parallele Korrektur von geschützten Datenströmen mit Fehlererkennung durch zyklisch redundante Prüfung
Système électronique pour la correction parallèle de flux de données protégées avec détection d'erreurs par test cyclique redondant

(30) Priority: 13.04.1990 IT 2003990
(43) Date of publication of application: 13.11.1991
(73) Proprietor: ALCATEL ITALIA S.p.A., 20149 Milano (IT)
(72) Inventor: Salvitti, Sergio, I-00166 Roma (IT)
(74) Representative: Graf, Georg Hugo, Dipl.-Ing.

(56) References cited:
- US-A- 3 859 630
- US-A- 4 498 174
- US-A- 4 665 523
- US-A- 4 868 828

## Description

The present invention relates to an electronic device for parallel correction of data streams protected with error detection by cyclic redundancy check.

Such a device is e.g. known from US-A-4 665 523

As generally known, in the field of data transmission it is important to protect data streams at the highest degree against transmission errors.

More in detail it is necessary that the received data streams are continuously checked to avoid alteration, namely the change of logic value of the bits forming the stream itself.

At the present time in order to correct data streams, protected in particular with error detection by cyclic redundancy check (CRC),the most used methods of correction are respectively, the look-up table method and the serial method with Meggit decoder.

In the first method a somewhat large circuitry is contemplated since the comparison of prefixed tables requires very complex circuits.

Such circuitry is very onerous to realize especially for very long data streams, for which circuit extension for the comparison of the above mentioned tables are necessary.

For such reasons this method, although very fast in operation, is slightly reliable as concerns the physical embodiment of the circuit and very expensive for the considerable number of required circuit elements.

Instead, the other method i.e. the serial method with Meggit decoder, performs the correction of serial data streams with a very simple circuitry.

However such method performs the correction only if the data stream has a serial form, whereas in the event the data stream has a parallel form, relative conversions have to be carried out.

From the above description it is evident that, according to the present state of the art, the circuit embodiments performing the parallel correction of data streams have some limitations according to the mentioned various aspects of the embodiment.

More appropriately the embodiments of the prior art have some limitations as concerns either velocity or circuit complexity.

The object of the present invention is to avoid and overcome the problems and the limitations of the prior art by providing an electronic device for parallel correction of data streams protected with error detection by cyclic redundancy check, that is simple and nevertheless allows a compromise operational rate especially when the data stream is already available in parallel form.

This and other objects, which will become more apparent from the following description, are achieved according to the present invention by an electronic device for parallel correction of data streams as described in claim 1.

Further features and advantages of the invention will be more apparent from the following detailed description of a preferred, but not exclusive, embodiment of an electronic device for parallel correction of data streams protected wich error detection by cyclic redundancy check, taken in cojunction with the attached drawings given as an indicative, and therefore not limitative, example where :
- fig. 1 is a schematic block diagram of the device according to the present invention ;
- fig. 2 illustrates the syndrome generator located in the device according to the present invention.

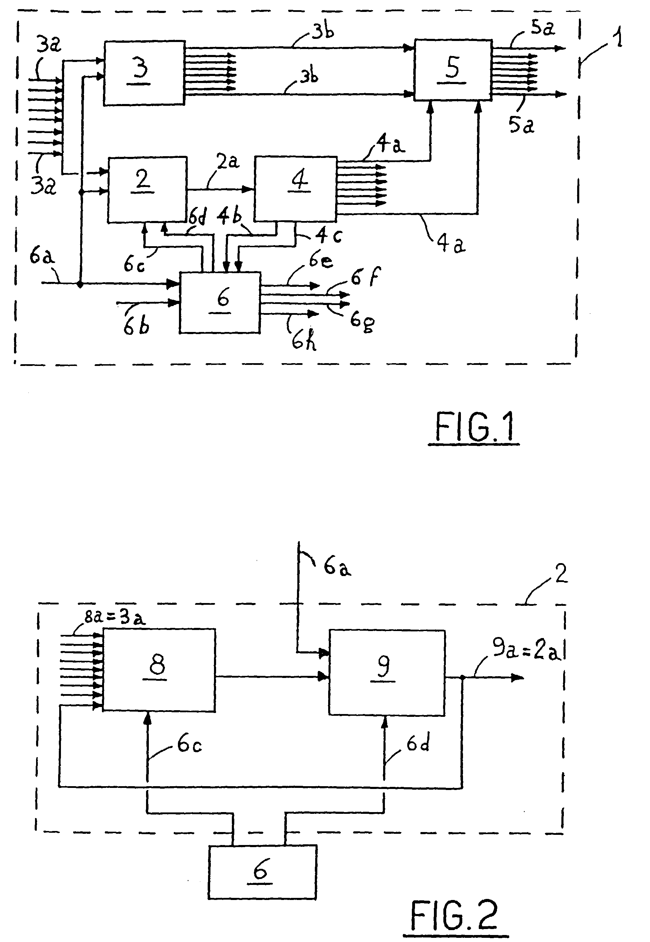

Referring now to figure 1, numeral reference 1 indicates as a whole the device according to the present invention.

Inside the device 1, is a syndrome generator 2 at whose input eight bit data strings 3a are entered and simultaneously sent to a delay circuit 3 consisting of a data buffer.

Data streams 2a are generated at the output of the syndrome generator 2 and sent to a particular decoder 4 which allows the recognition of the null syndrome and at least eight syndrome configurations.

The decoded output of null syndrome, represented by line 4b, is connected to the control logic 6, while the other eight decoded outputs, corresponding to the recognition one of the contemplated eight syndrome configurations, represented by lines 4a, are directed, in parallel form, to a correction circuit 5 consisting of a modulo-two adder, at whose outputs the outcoming bytes 5a, eventually corrected, are generated.

A control logic 6 allows the handling of the syndrome generator 2 so that, at the end of the operations, at its outputs 6g and 6h, there are : either a signalling of string received as corrected or a signalling of string received wrong and then subsequently corrected, or a signalling of string received wrong and not correctable.

The whole system is handled by a byte clock 6a and by a string start signal 6b.

The syndrome generator 2 is illustrated more in detail in figure 2.

Inside the generator is a combinatorial logic 8, at whose input the eight bits represented by lines 8a are directed.

At the output of such block 8, m bits are generated and successively sent to a register 9 acting as temporary storage.

Then, the control logic 6 allows to carry out either the syndrome calculation of the incoming byte string or the cyclic generation of code words adjacent to the syndrome calculated by means of a control signal 6c. Moreover, the control logic can reset the register 9 through the signal 6d.

In any case an output 9a, which represents the syndrome resulting from the processing of syndrome generator 2, outputs from such block 2.

The operation of the above mainly structural description of the device 2 follows.

From the functional viewpoint, the device 2 calculates the syndrome of an incoming data stream in parallel form with an eight bit parallelism. It provides also the cyclic generation of code words adjacent to the calculated syndrome.

The syndrome generator 2 may be compared to a machine with consecutive states having : eight inputs 8a, m outputs 9a, m being equal to the degree of the generative polynomial selected for the error control field of the data stream to be protected.

Register 9 is an m bit register and is used to memorize the status of the finite state machine, namely the syndrome.

The combinatorial logic circuit 8 consists essentially of a plurality of gates most of them being of Exclusive OR type, having m+8 inputs that is as many as the bits 8a entering the syndrome generator plus the bits 9a of the syndrome generator output which are looped as negative feedback . Finally, at the output 9a of the value of the syndrome calculated up to the preceding state, while at the input of register 9 is the value of the syndrome calculated by taking into account the last byte entered at the input 8a.

The control input 6c acts for cyclic generation of code words abjacent to the calculated syndrome. More in detail, when this signal is active, data at the input 8a are disabled whereby a bit configuration consisting of all zeroes is entered.

Essentially the operation of the circuit in figure 1 may be subdivided into three operative phases.

The first one, initialization phase, driven from outside through the activation of the synchronism signal 6b, contemplates that control logic 6 resets the register 9 located inside the syndrome generator 2, through the reset signal 6d.

The second one, calculation phase , driven from outside by the byte clock signal 6a, contemplates entering the data stream, one byte at a time, into memory 9 and the simultaneous calculation of the syndrome. The end of this phase is automatically individuated by the control logic computing the entered n number of bytes. At this point the control logic 6 scans the state of input 4b to see if the calculated syndrome is null.

The third and last phase goes on following the byte clock 6a. From now on the control logic starts the correction phase through the activation of signal 6c so that the syndrome generator may generate the code words adjacent to the syndrome calculated in the preceding phase. The output signal 6f, informing about validity of data at output 5a, and the output byte clock signal 6c follows the input byte clock signal 6a even if with an appropriate phase shift. In conclusion the output bytes can be sampled with the clock signal 6e when the signal 6f is active.

During the correction phase, decoder 4 scans input 2a and, in case of recognition of one of the contemplated eight configurations, it individuates the position of the wrong bit inside the byte at the output 3b and activates the corresponding line of sheaf 4a while sending simultaneously a signalling to the block 6 via line 4c. The parallel correction circuit 5 inverts automatically the value of the wrong bit.

At the end of the correction phase, going on n bytes, as many as the bytes forming the data stream including the error protection field, the control logic 6 emits a response signal about the operations which have been carried out. In particular the wire 6h will signal if an error has been detected at the end of the syndrome calculation phase, whereas the wire 6g, upon an error detection, will signal if the latter has been corrected.

For simplicity the correction step is always carried out even if the data stream is already corrected at the end of the syndrome calculation phase.

The invention thus achieves the above objects.

In fact the device, even being more complex than Meggit decoder, is however faster, since it works with an eight bit parallelism.

This device may be very useful in dedicated circuits not fast, like CMOS where the circuit complexity is not a bounding parameter.

Moreover this device may be useful when the correction of single errors is required.

Obviously, other parametric and circuit modifications are also possible all falling within the scope defined by the claims.

## Claims

1. Electronic device for parallel correction of a data stream protected with error detection by cyclic redundancy check, said electronic device comprising a syndrome generator (2) at the input of which an eight bit data string (3a) is entered, the latter data string (3a) being at the same time entered at the input of a delay circuit (3), characterized in that said syndrome generator (2) and said delay circuit (3) are controlled by a control logic (6) which, upon correction carried out by a decoder (4) and a parallel correction unit (5), allows its outputs (6e, 6f, 6g, 6h) to signal an error detection event or a carried out correction, said decoder (4) being coupled to said syndrome generator (2) and being provided to detect the presence of one of eight contemplated syndrome configurations and to emit, upon detection of the presence thereof, a correction signal (4a) corresponding to the wrong bit, said correction signal (4a) being sent to said parallel correction unit (5) located at the output of said delay circuit (3) to automatically invert said wrong bit.

2. Electronic device according to claim 1, characterized in that said syndrome generator (2) consists of an Exclusive Or combinatorial logic circuitry (8) having m+8 inputs and m outputs, connected to a register (9) having m bits as many as the degree of the polynomial generating the selected cyclic code-register (9), both circuitries (8, 9) being connected to the control logic (6) of the device itself.

3. Device according to claim 1, characterized in that the delay circuit (3) consists of a data buffer.

4. Device according to claim 2, characterized in that the combinatorial logic circuit (8) which is present in the syndrome generator (2) has a control input (6c) which is activated when the input data (3a) are disabled.

5. Device according to claim 1, characterized in that the device is arranged to provide essentially an initialization phase in which the control logic (6) resets the syndrome register (9) located inside the syndrome generator (2), as well as a calculation phase in which data streams (3a) are entered both into the syndrome generator (2) and the delay circuit (3) so that, at the end of these phases, the control logic (6) can individuate whether the data stream (3a) is corrected or not, and finally a correction phase in which the control logic (6) loops the syndrome generator (2), while, at the same time, the decoder (4) and parallel correction unit (5) perform the correction, the control logic (6) emitting then a signal in the event of error and/or a carried out correction signal according to the result of the calculated syndrome and to the recognition of one of the pre-established eight configurations.

## Patentansprüche

1. Elektronisches Gerät zur parallelen Korrektur eines mit Fehlererkennung durch zyklische Blockprüfung geschützten Datenstroms, wobei das elektronische Gerät einen Syndromgenerator (2) umfaßt, an dessen Eingang eine Acht-bit-Datenfolge (3a) eingegeben wird, wobei letztere Datenfolge (3a) gleichzeitig am Eingang einer Verzögerungsschaltung (3) eingegeben wird, dadurch gekennzeichnet, daß der Syndromgenerator (2) und die Verzögerungsschaltung (3) von einer Steuerlogik (6) gesteuert werden, die nach der von einem Decodierer (4) und einer Parallelkorrektureinheit (5) durchgeführten Korrektur ihren Ausgängen (6e, 6f, 6g, 6h) erlaubt, ein Fehlererkennungsereignis oder eine durchgeführte Korrektur zu signalisieren, wobei der Decodierer (4) mit dem Syndromgenerator (2) verbunden und bereitgestellt ist, um das Vorhandensein von einer von acht in Betracht gezogenen Syndromkonfigurationen festzustellen und um, nachdem er deren Vorhandensein festgestellt hat, ein dem falschen Bit entsprechendes Korrektursignal (4a) auszusenden, wobei das Korrektursignal (4a) an die Parallelkorrektureinheit (5), die sich am Ausgang der Verzögerungsschaltung (3) befindet, gesandt wird, um das falsche Bit automatisch zu invertieren.

2. Elektronisches Gerät nach Anspruch 1, dadurch gekennzeichnet, daß der Syndromgenerator (2) aus einer kombinatorischen Exklusiv-ODER-Logikschaltung (8) mit m+8 Eingängen und m Ausgängen besteht, die mit einem Register (9) verbunden ist, das m Bits, so viele wie der Grad des Polynoms, welches das Register für den ausgewählten zyklischen Code (9) erzeugt, hat, wobei beide Schaltungen (8, 9) mit der Steuerlogik (6) des Bauelements selbst verbunden sind.

3. Gerät nach Anspruch 1, dadurch gekennzeichnet, daß die Verzögerungsschaltung (3) aus einem Datenpuffer besteht.

4. Gerät nach Anspruch 2, dadurch gekennzeichnet, daß die kombinatorische Logikschaltung (8), die im Syndromgenerator (2) vorhanden ist, einen Steuereingang (6c) hat, der aktiviert wird, wenn die Eingabedaten (3a) gesperrt werden.

5. Gerät nach Anspruch 1, dadurch gekennzeichnet, daß das Bauelement so angeordnet ist, daß es im wesentlichen eine Initialisierungsphase, in der die Steuerlogik (6) das im Syndromgenerator (2) befindliche Syndromregister (9) zurücksetzt, als auch eine Berechnungsphase, in der Datenströme (3a) sowohl in den Syndromgenerator (2) als auch in die Verzögerungsschaltung (3) eingegeben werden, so daß die Steuerlogik (6) am Ende dieser Phasen angeben kann, ob der Datenstrom (3a) korrigiert wird oder nicht, und schließlich eine Korrekturphase vorsieht, in der die Steuerlogik (6) den Syndromgenerator (2) in einer Schleife durchläuft, während der Decodierer (4) und die Parallelkorrektureinheit (5) gleichzeitig die Korrektur durchführen, wobei die Steuerlogik (6) dann im Falle eines Fehlers und/oder einer durchgeführten Korrektur entsprechend dem Ergebnis des berechneten Syndroms und entsprechend der Erkennung von einer der vorher festgelegten acht Konfigurationen ein Signal aussendet.

## Revendications

1. Système électronique pour correction en parallèle de flux de données protégés avec détection d'erreur par contrôle par redondance cyclique, le dit système électronique étant composé d'un générateur de syndrome (2) à l'entrée duquel une chaîne de données de huit bits (3a) est introduite, cette dernière chaîne de données (3a) étant en même temps introduite à l'entrée d'un circuit de temporisation (3), caractérisé par le fait que le dit générateur de syndrome (2) et le dit circuit de temporisation (3) sont contrôlés par une fonction logique de contrôle (6) qui, lors de la correction effectuée par un décodeur (4) et une unité de correction en parallèle (5), permet à leurs sorties (6e, 6f, 6g, 6h) de signaler une éventuelle détection d'erreur ou une correction effectuée, le dit décodeur (4) étant couplé au dit générateur de syndrome (2) et étant prévu pour détecter la présence de l'une des huit configurations de syndrome envisagées, et pour émettre, lors de la détection de leur présence, un signal de correction (4a) correspondant au bit erroné, le dit signal de correction (4a) étant envoyé à la dite unité de correction en parallèle (5) située à la sortie du dit circuit de temporisation (3) pour inverser automatiquement le dit bit erroné.

2. Le système électronique selon la revendication 1, caractérisé par le fait que le générateur de syndrome (2) est composé d'une technique de câblage logique combinatoire OR Exclusive (8) ayant m+8 entrées et m sorties, connectées à un registre (9) ayant m bits autant que le degré du polynomial générant le registre code cyclique sélectionné (9), les deux circuits (8, 9) étant connectés à la fonction logique de contrôle (6) du système lui-même.

3. Le système selon la revendication 1, caractérisé par le fait que le circuit de temporisation (3) consiste en une mémoire tampon de données.

4. Le système selon la revendication 2, caractérisé par le fait que le circuit logique combinatoire (8) qui est présent dans le générateur de syndrome (2) a une entrée de contrôle (6c) qui est activée lorsque les données à l'entrée (3a) sont invalidées.

5. Le système selon la revendication 1, caractérisé par le fait que le système est prévu pour fournir essentiellement une phase d'initialisation dans laquelle la fonction logique de contrôle (6) ré-initialise le registre de syndrome (9) situé dans le générateur de syndrome (2), ainsi qu'une phase de calcul dans laquelle les flux de données (3a) sont introduits à la fois dans le générateur de syndrome (2) et dans le circuit de temporisation (3) de manière à ce que, à la fin de ces phases, la fonction logique de contrôle (6) puisse repérer si le flux de données (3a) est corrigé ou non, et finalement une phase de correction dans laquelle la fonction logique de contrôle (6) forme une boucle avec le générateur de syndrome (2), alors que, dans le même temps, le décodeur (4) et l'unité de correction en parallèle (5) réalisent la correction, la fonction logique de contrôle (6) émettant alors un signal dans l'hypothèse d'une erreur et/ou un signal de correction effectuée en fonction du résultat du syndrome calculé et de la reconnaissance de l'une des huit configurations préétablies.
